# EUROPEAN PATENT APPLICATION

(11) **EP 0 559 934 A1**
(43) Date of publication of application: **15.09.1993**
(21) Application number: 92104161.2
(22) Date of filing: 11.03.1992
(51) Int. Cl.: G03F 7/20, G03F 7/30

(54) **Method and apparatus for deep UV image reversal patterning**

(71) Applicant: International Business Machines Corporation, Armonk, N.Y. 10504 (US)
(72) Inventor: Moritz, Holger, Dipl.-Phys., W-7038 Holzgerlingen (DE)
(74) Representative: Schäfer, Wolfgang, Dipl.-Ing.

(57) **Abstract**

A method of deep UV image reversal lithography is disclosed that allows high resolution patterning of standard resists. For this a standard photoresist 1, comprising a top layer reversal image 4 of a desired pattern, is exposed to deep UV light 31 during developing process. Hereby the top layer reversal image serves as a blocking mask 5 for the impinging deep UV light 31. Only free areas 8 are thus illuminated and simultaneously developed. This results - comparable to anisotropic etching - in a gradual transfer of the reversal image from the top layer through the resist.

## Description

The invention in general relates to imaging techniques. More specifically the invention concerns photolithographic techniques used in the manufacture of integrated circuits and other microminiature components.

Presently integrated circuits with structures of submicron dimensions are produced. These structures are commonly formed by lithographic techniques using UV light for illuminating patterned areas.

With ongoing trend to miniaturisation attempts to further increase integrated circuit densities encounter several problems:
Minimum feature sizes in the 0.3 µm region require higher resolution projection lenses, which in turn triggers usage of shorter wavelengths for the image transfer from the mask to the projection plane. To balance resolution and depth of focus requirements advanced exposure tools therefore will employ excimer laser radiation of 248 nm wavelength. Unfortunately the commercially available Novolak-based photoresists are highly absorbant at wavelengths below about 300 nm. The radiation will penetrate only the top 0.2 µm of the resist film and lower parts of the resist are not illuminated. Preparing of thin films with about 0.2 µm thickness is possible, but these films are too thin to safely cover surface topology of the substrate. Such topology is typical for integrated circuits on substrate wafers.

To solve these problems there are two methods known in the art: either to use multilayer resist techniques or to develop new photoresists being transparent for deep UV radiation. The drawbacks of such deep UV resists are basically twofold:
1. Since they are designed to be transparent to deep UV, they suffer from interference effects, such as standing waves, and a high sensitivity of the energy coupled into the film to film thickness variations, which inevitably occur at topology steps.
2. Deep UV resist formulations known today are based on chemical amplification schemes and thus are highly sensitive to sub-ppm-level gases in the atmosphere.

The drawbacks of multilayer methods are mainly costs, due to the extra equipment and processing unit hours needed, and due to the yield loss associated with the extra processing.

The present invention is intended to provide a new method of deep UV imaging which overcomes problems and drawbacks inherent in known techniques.

This is achieved by the inventive method as claimed, in which a standard photoresist, comprising a top layer reversal image of a desired pattern, is exposed to deep UV light during developing process. Hereby the top layer reversal image serves as a blocking mask for the impinging deep UV light. Only free areas are thus illuminated and simultaneously developed. This results - comparable to anisotropic etching - in a gradual transfer of the reversal image from the top layer through the resist.

For a better understanding of the present invention, together with further objects and advantages, a detailed description of the method of the present invention is given in the following with reference to the accompanying drawings, in which
- Figure 1: is a schematic drawing of a substrate 2 covered with a resist 1, sensitive for deep UV radiation;
- Figure 2: illustrates deep UV illumination 3 of local surface areas 4 of the resist 1, whereby due to absorption effects only a top resist layer is affected;
- Figure 3: shows stabilized areas 5, which are formed out of illuminated areas 4 by a baking process step;
- Figure 4: demonstrates the anisotropic forming of contours 7 by exposing the resist to a developer 6 and simultaneously illuminating the resist with collimated deep UV radiation;
- Figure 5: shows the finally resulting structure of remaining resist 9 and uncovered substrate surface areas 10.

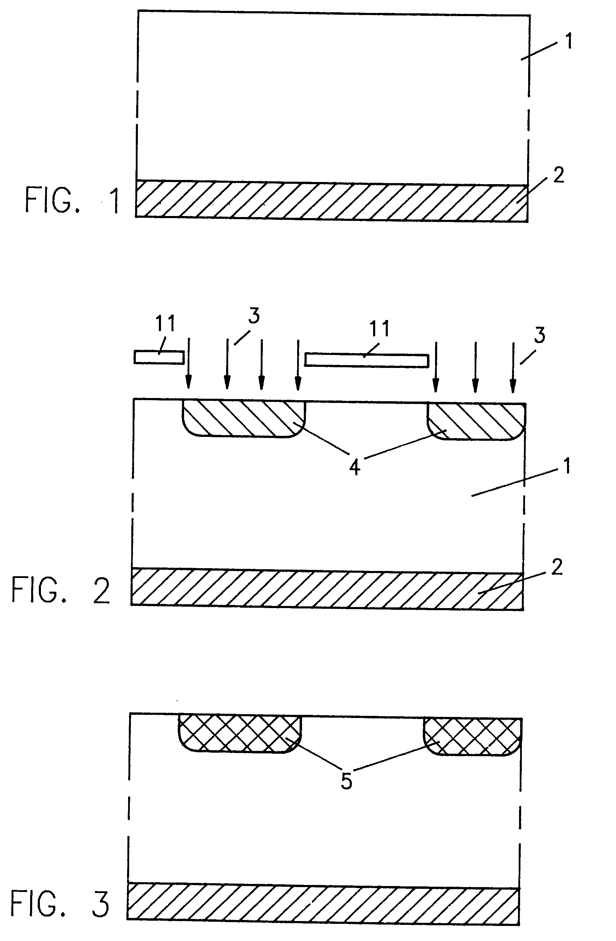

According to Figure 1 in a first process step an image reversal resist 1 is coated over a substrate 2, on which structures are to be formed by lithographic techniques. The coating can be performed by usual techniques, like e.g. spinning or spraying. It is a specific advantage of the present invention that conventional well known and production proven photoresists can be used. For example 'HOECHST AZ 5214 E' can be taken as a representative resist but other commonly available resists of the above specified type would be suitable as well.

A useful thickness of the resist 1 generally will be in the micron range, say about 1.5 µm. This thickness several times exceeds the depth of transparency, with respect to deep UV radiation, which is typically about 0.2 µm. The resist therefore serves as a perfect antireflection coating as no deep UV radiation will reach the surface of the substrate.

Only one single layer of resist is necessary. Comprising said thickness in the micron range it will planarize over substrate topology, thus the present method allows minimizing the depth-of-focus requirements.

In a second process step a reverse image of the desired pattern is generated in a top layer of said resist as shown in Figure 2. For this the resist 1 is exposed to deep UV light 3 through a respective mask 11. UV light 3 will be absorbed within a small zone below the resin's top surface and not reach the substrate 2.

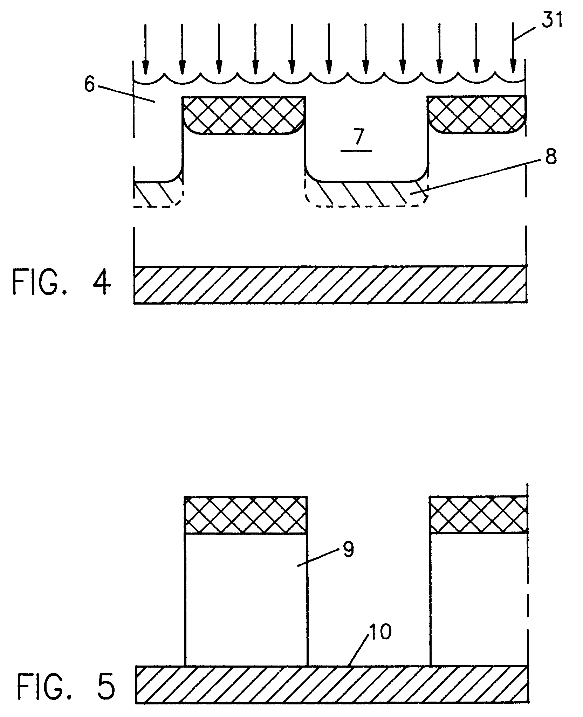

Illuminated areas 4 are stabilized in a subsequent reversal bake process (Figure 3). The image-wise exposed resist is crosslinked during the reversal bake thus forming an effective mask 5 to protect the resist below against deep UV radiation. In addition the crosslinked areas 5 show a significantly reduced solubility in developers, typically less then 0.1 nm per second.

As shown in Figure 4 in a following process step the resist then is exposed to a developer 6, whereby simultaneously the resist is illuminated with deep UV light 31. All surface regions of the resist, which have been not crosslinked during reversal bake, are still sensitive to deep UV light. In these regions the resist is locally modified by the UV radiation and becomes soluble in the developer. Consequently the developer dissolves exclusively these modified (illuminated) parts 8 of the resist. As these parts, which initially comprise e.g. said thickness of 0.2 µm - depending of the resist's transparency to deep UV - are removed by the developer, deep UV radiation reaches underlaying resist, exposes and solubilizes it. It will then be removed by the developer, exposing now even lower resist layers to the radiation and so on. This results in a gradual and anisotropic patterning of the resist, defined by said masking areas 5.

By using a collimated deep UV source the UV light can be directed in a manner to vertically impinge onto the resist's surface. As shown in Figure 5 finally remaining structures 9 of resist pattern will then comprise rectangular shapes with respect to the substrate's surface 10. For specific applications it is of course possible to choose other directions of collimated deep UV light to e.g. produce an 'undercut' of masking areas 5.

The method of the present invention allows high resolution patterning of standard resists. There are no extra process steps in comparison to conventional lithography as only deep UV exposure is required during developing which can be done in usual tools without major amendments.

## Claims

1. Method of lithographic patterning of photoresist, comprising the steps of
a) coating a substrate (2) with photoresist to create a photoresist layer (1) of a first thickness,
b) illuminating the surface of said photoresist through a mask (11) with light (3), having a wavelength chosen so that the depth of transparency in said photoresist for said illuminating light is a fractional part of said first thickness of said photoresist layer (1), whereby a reverse image (4) is generated in a surface region of the resist, said region having a second thickness corresponding to said depth of transparency,
c) stabilizing said reverse image (4) in said photoresist layer (1) in a subsequent reversal bake process, whereby illuminated areas of said photoresist are crosslinked,
d) exposing said photoresist layer (1) to a developer (6) of a type, selected to dissolve exclusively illuminated, non-stabilized photoresist, and simultaneously illuminating said photoresist layer (1) with light (31) of a wavelength and intensity capable to modify selectively those areas (8) of said photoresist, which were not stabilized during baking in such a manner, that these areas (8) are dissolved by said developer (6),
whereby said reverse image (4) is gradually transferred through said photoresist layer (1).

2. Method of claim 1, wherein said step d) of exposing and simultaneously illuminating said photoresist is continued until local parts of the substrate's surface (10) are uncovered from said photoresist.

3. Method of claim 1 or 2, wherein said light (31), used for illuminating said photoresist simultaneously while developing, is collimated and projected to the surface of said photoresist layer (1) at an angle, said angle defining the direction of gradual transfer of said reverse image (4).

4. Method of claim 3, wherein said angle comprises about 90 degrees.

5. Method of any one of the preceding claims, wherein said mask (11)
comprises spacings of submicron range.

6. Method of any one of the preceding claims, wherein said reversal baking step for stabilizing said reverse image (4) in said photoresist layer (1) is carried out at a temperature of about 100 degrees and for a duration of about 3 minutes.

7. Method of any one of the preceding claims, wherein said substrate (2) has a surface (10) which comprises a topology and whereby said photoresist is deposited on said substrate (2) to form said photoresist layer (1) comprising said first thickness sufficient to planarize over said topology.

8. Apparatus for implementing the method as recited in any one of the preceding claims, wherein said light (3,31) for illuminating said photoresist is UV, preferably deep UV radiation.

9. Apparatus of claim 8, wherein said UV or deep UV radiation (3,31) is generated by a laser source, preferably an eximer laser source.

10. Apparatus of claim 8 or 9, wherein said substrate (2) consists of different layers or structures.
